(19) Europäisches Patentamt
European Patent Office
Office européen des brevets

(11) EP 0 598 390 B1

## (12) EUROPEAN PATENT SPECIFICATION

(45) Date of publication and mention
of the grant of the patent:
**15.10.1997 Bulletin 1997/42**

(51) Int Cl.6: **H03H 7/48**

(21) Application number: **93118506.0**

(22) Date of filing: **16.11.1993**

(54) **Variable RF power splitter**

Variabler Hochfrequenzleistungsverteiler

Diviseur de puissance haute-fréquence variable

(84) Designated Contracting States:
**DE ES FR GB IT NL**

(30) Priority: **17.11.1992 US 977353**

(43) Date of publication of application:
**25.05.1994 Bulletin 1994/21**

(73) Proprietor: **APPLIED MATERIALS, INC.**
**Santa Clara, California 95054-3299 (US)**

(72) Inventors:
• **Collins, Kenneth S.**
**San Jose, California 95111 (US)**
• **Trow, John R.**
**San Jose, California 95111 (US)**
• **Roderick, Craig A.**
**San Jose, California 95117 (US)**

(74) Representative:
**Diehl, Hermann, Dr. Dipl.-Phys. et al**
**DIEHL, GLÄSER, HILTL & PARTNER**
**Patentanwälte**
**Flüggenstrasse 13**
**80639 München (DE)**

(56) References cited:
US-A- 4 680 559          US-A- 4 823 096
US-A- 4 887 005

## Description

The present invention relates to RF power splitter apparatus for splitting a radio frequency (RF) electrical signal between two loads, and, more specifically, to an RF power splitter which permits adjusting the ratio of the RF voltage applied to the two loads.

There are many applications in which it is desirable to be able to divide a high power RF signal between two loads and adjust the ratio of voltage applied to the two loads. In some applications, it is important that the voltage split ratio and phase differential between the two outputs of the splitter be substantially independent of changes in impedance of the two loads. For example, when an RF power splitter is used to supply power to two electrodes of a plasma reaction chamber, the impedance of the plasma varies dynamically as a function of changing operating conditions such as gas pressure in the chamber, temperature, and RF power level. To maximize the stability of the plasma, the two output voltages of the RF power splitter should have as little sensitivity as possible to changes in the two load impedances it is driving.

Examples of plasma reactors having RF power splitters for supplying power to two electrodes are US-A- 4,871,421 granted Oct. 3, 1989 to Ogle et al. for a "Split Phase Driver for Plasma Etch System", and US-A- 4,887,005 granted Dec. 12, 1989 to Rough et al. for a "Multiple Electrode Plasma Reactor Power Distribution System".

Known RF power splitters include RF transformers in which wipers or multiple taps permit adjustment of the voltage split ratio. However, this requires the use of mechanical switch contacts or wipers which suffer deterioration over time.

Other known RF power splitters consist of networks of inductors and capacitors in which one or more of the inductors or capacitors is variable so as to adjust the ratio of voltage applied to two loads. However, in known networks of this type, the voltage split ratio and the phase differential between the two output signals generally are very sensitive to the impedances of the loads. Also, in such networks the relative phase angle between the two output signals changes substantially as the power split ratio is varied.

Accordingly it is an object of this invention to provide an RF power splitter which can adjust the ratio of voltage applied to two loads over a wide range without imposing excessive changes in the relative phases of the two output signals and with minimal sensitivity to changes in the impedances of the two loads.

This object is solved by an RF power splitter of independent claim 1. Further advantageous features, aspects and details of the invention are evident from the dependent claims, the description and the drawings. The invention is defined by the appended claims.

The present invention is an RF power splitter which permits adjusting the ratio of voltage applied to two loads. The present invention can be adjusted so that the output signals maintain a relatively constant phase relationship as the voltage ratio between the two output signals is adjusted, and so that the voltage split ratio is relatively unaffected by dynamic changes in the impedances of the two loads.

Specifically, the novel RF power splitter comprises three mutually coupled inductors connected in series so that the first inductor is connected between a first terminal and a second terminal, the second inductor is connected between the second terminal and a third terminal, and the third inductor is connected between the third terminal and a fourth terminal. The RF power input is connected between one of the four terminals and a fifth terminal, referred to as the ground terminal. A variable reactance is connected between a different one of the first four terminals and the ground terminal. The first and second loads are respectively connected between the first and second of the remaining two terminals and the ground terminal.

In operation, adjusting the variable reactance changes the ratio of voltage provided to the two loads. To avoid any need for mechanical moving parts, the variable reactance can be a fixed capacitor in series with a saturable inductor whose inductance is controlled by an electrical control current.

Figures 1 and 2 are electrical schematics of first and second alternative embodiments of the RF power splitter of the present invention.

Figure 3 is an electrical schematic of a conventional variable inductor which is the preferred implementation of the variable reactance in the RF power splitters shown in Figures 1 and 2.

Figure 4 is a sectional view of the inductors used to implement the power splitters of Figures 1 and 2.

Figure 5 is a graph of the magnitudes of both output voltages as a function of the value of the variable inductor in the first embodiment of the power splitter. The voltages in the graph are normalized, assuming a one volt rms input from the RF voltage source.

Figure 6 is a graph of the magnitude ratio and phase difference between the two output voltages as a function of the value of the variable inductor in the first embodiment of the power splitter.

Figure 7 is a graph of the magnitude and phase of the input impedance of the first embodiment of the RF power splitter as a function of the value of the variable inductor.

Figures 8 - 10 are graphs corresponding to Figures 5 - 7, respectively, for the second embodiment of the RF power splitter.

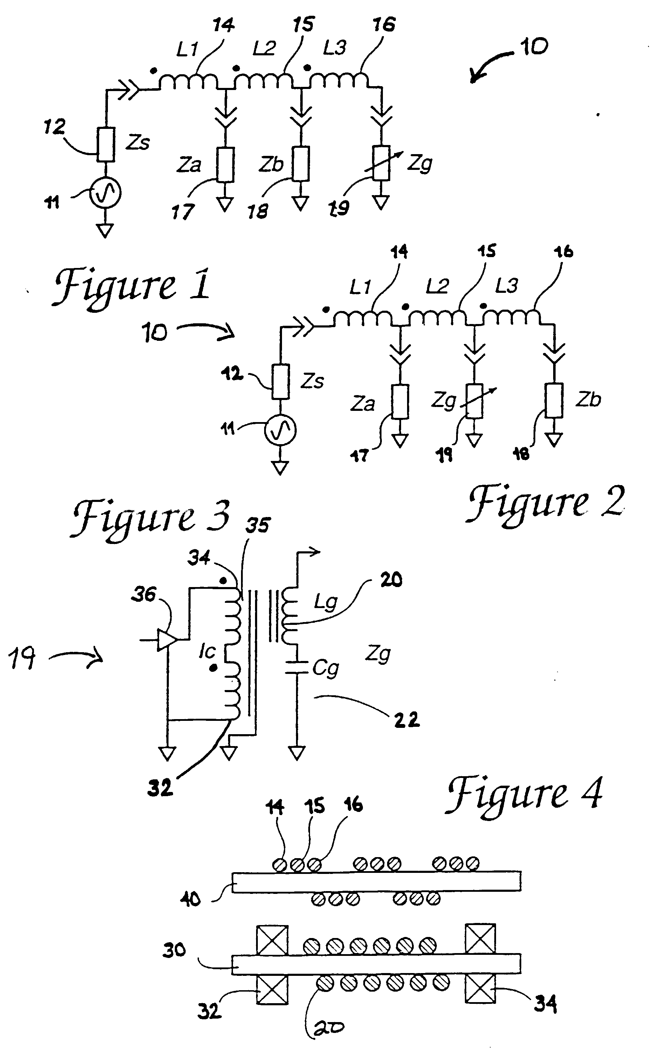

Figure 1 is an electrical schematic of the first of two preferred embodiments of an RF power splitter according to the present invention. An RF signal is provided by an RF power source 10 which is modelled in the schematic as an ideal RF voltage source 11 in series with a source impedance 12 whose complex value is represented as $Z_s$. The power source is connected to one end of first inductor 14, which in turn is connected in series with second and third inductors 15 and 16, respectively. The three inductors 14-16 are mutually coupled and are series-connected in phase. In Figure 1, a dot at one end of each inductor represents inductor terminals having common phase. Preferably, the mutual coefficient of coupling among the three inductors is as high as possible, and is roughly 0.8 in the preferred embodiment.

The first load 17 is represented as having a complex impedance $Z_a$ and is connected at one end to the junction of the first and second inductors and at the other end to the ground terminal of the RF power source 10. Similarly, the second load 18 having complex impedance $Z_b$ is connected between the junction of the second and third inductors and ground. Lastly, a variable reactance 19 having complex impedance $Z_g$ is connected between the otherwise unconnected end of the third inductor 16 and ground.

In operation, the RF voltage provided by the RF power source 10 is coupled through the RF power splitter network to the two loads 17 and 18. The ratio of voltage supplied to the two loads may be adjusted by varying the reactance of variable reactance 19.

Figure 2 shows an alternative but equally preferred implementation of the RF power splitter which is identical to the embodiment shown in Figure 1 except that the second load 18 and the variable reactance 19 are interchanged. The difference in performance of these two implementations will be analyzed below.

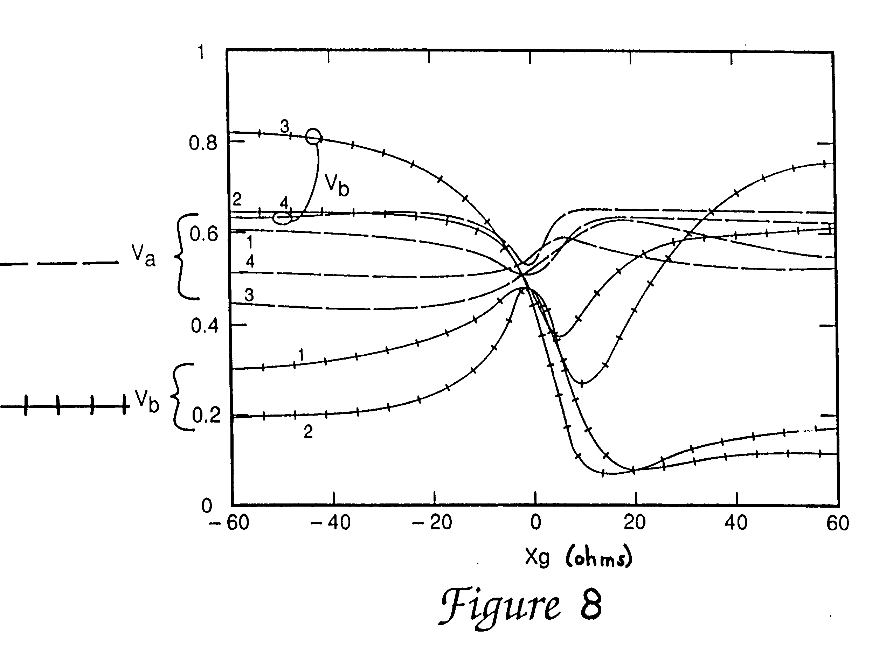

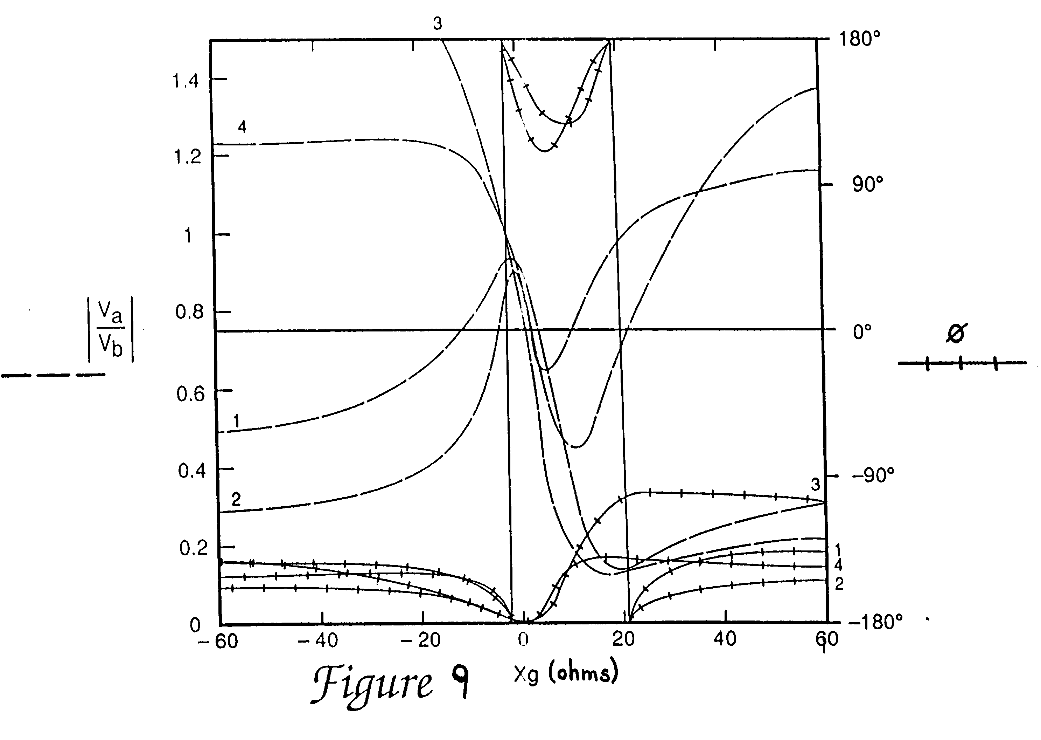

Figures 3 and 4 show the preferred implementation for the variable reactance 19. It is a fixed capacitor 22 (having capacitance $C_g$) connected in series with a conventional saturable inductor 20 (having inductance $L_g$) in which an electrical control signal controls the value of an inductor. A detailed description of such a variable inductor appears in commonly assigned US-A- 4,951,009 by Kenneth S. Collins, one of the inventors of the present invention. That patent is hereby incorporated by reference into this description in its entirety. In particular, preferred implementations of the variable inductor 20 are described in Figures 8 - 11 of the patent and the corresponding text.

Referring to Figures 3 and 4, variable inductor 20 is wound around a saturable (i.e., non-linear) ferromagnetic core 30. Also wound around core 30 is a control winding, which preferably is implemented as two control windings 32 and 34, interconnected in series or in parallel, which are wound on opposite ends of core 30 with inductor winding 20 between them, as shown in Figure 4. The magnetic properties of saturable core 30 and the number of windings of each of the three coils 20, 32, and 34 are chosen so that the inductance of inductor 20 can be adjusted by varying the current through the control windings 32 and 34, but will not be affected by variations in the current through inductor 20 at the intended RF power levels. A conventional amplifier 36 can be used to control the current through the control windings to adjust the value of inductor 20. This electrical control system avoids any need for mechanical devices to adjust the power split ratio of the RF power splitter.

Preferably, the variable inductor 20 ($L_g$) and fixed capacitor 22 ($C_g$) have values chosen so that, at the midpoint of the adjustment range for the inductor 20, the series resonance frequency of the variable reactance 19 ($Z_g$) equals the frequency of the RF power source 10. Accordingly, as the inductance of inductor 20 is adjusted to values lower and higher than this midpoint, the reactance 19 ranges from capacitive (negative reactance) to inductive (positive reactance).

Although variable reactance 19 alternatively could be implemented as a fixed inductor in series with a conventional variable capacitor having a mechanically adjustable rotor plate, it is preferable to avoid the use of moving parts so as to avoid problems of mechanical wear.

Figure 4 also shows the preferred implementation of the three mutually coupled inductors 14, 15 and 16. To maximize their mutual coefficient of inductive coupling, they are constructed as a trifilar winding on a ferromagnetic core 40. This core 40 is not magnetically coupled to saturable core 30. They are shown adjacent to each other in Figure 4 because that is an actual preferred physical implementation.

To demonstrate the performance of the present invention, RF power splitters according to the first embodiment shown in Figure 1 and the second embodiment shown in Figure 2 were modelled on a computer. The RF power source 10 was assumed to have a 1.8 MHz frequency and a 50 ohm source impedance $Z_s$. The three mutually coupled inductors 14, 15 and 16 were each assumed to have a self inductance ($L_1$, $L_2$ and $L_3$) of 1.5 microhenries and a pairwise coefficient of coupling ($K_{12}$, $K_{23}$ and $K_{13}$) of 0.8.

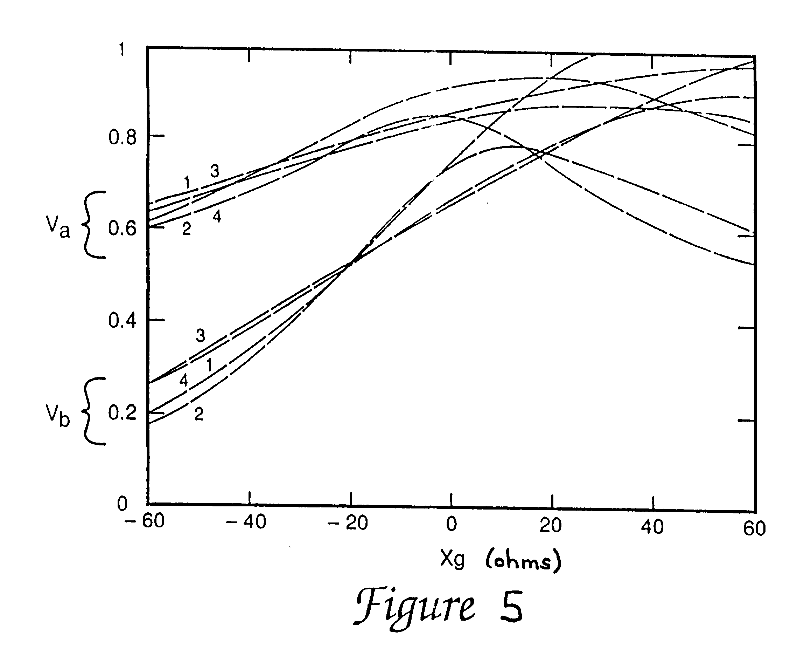

Figures 5-7 show the results for the computer model of the Figure 1 embodiment, and Figures 8-10 correspond to the Figure 2 embodiment.

In each graph the horizontal axis depicts the value of variable reactance 19 being varied from -60 ohms to +60 ohms (where negative and positive reactances represent capacitance and inductance, respectively). In the mathematical model from which these graphs were produced, the inductor 20 was assumed to have a DC resistance of 0.6 ohms.

To illustrate the relative independence of the output power split ratio and phase differential as a function of load impedance, each graph includes four numbered curves representing different load impedances. In each case, the loads are assumed to be capacitive with an impedance phase angle of -45°. Such a load impedance is a good model of the impedance of the plasma sheath, assuming the RF power splitter is being used to drive two electrodes in a plasma chamber. To model the sensitivity of the voltage split ratio to changes in the two load impedances respectively connected to the two outputs of the RF power splitter, four curves were computed for four combinations of load impedances as follows:

Curve 1: $|Z_a| = 52\Omega$; $|Z_b| = 21\Omega$.

Curve 2: $|Z_a| = 26\Omega$; $|Z_b| = 10.6\Omega$.

Curve 3: $|Z_a| = 21\Omega$; $|Z_b| = 52\Omega$.

Curve 4: $|Z_a| = 10.6\Omega$; $|Z_b| = 26\Omega$.

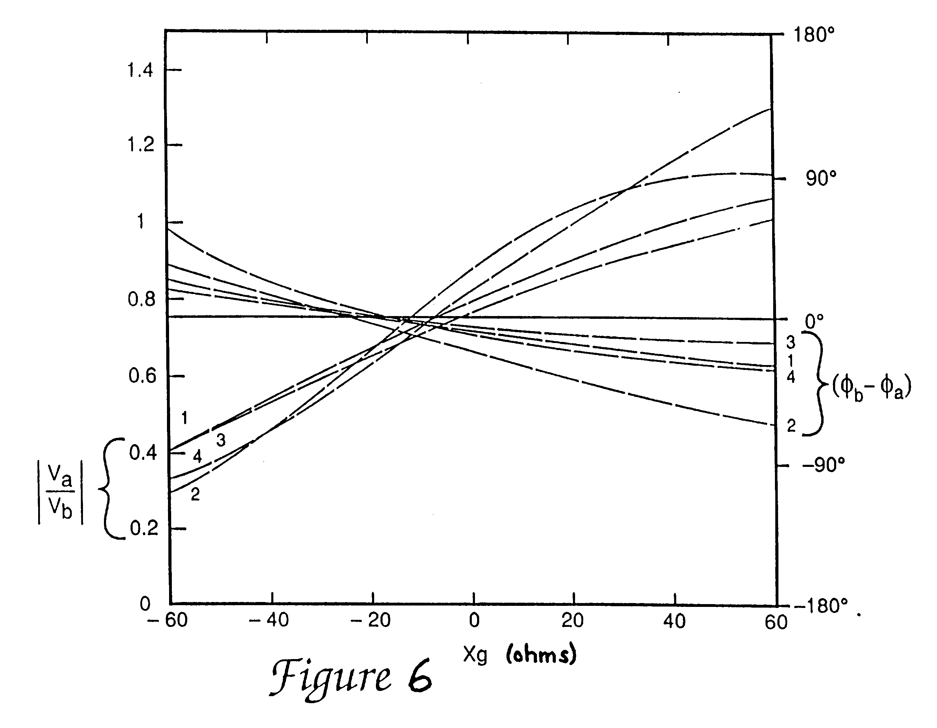

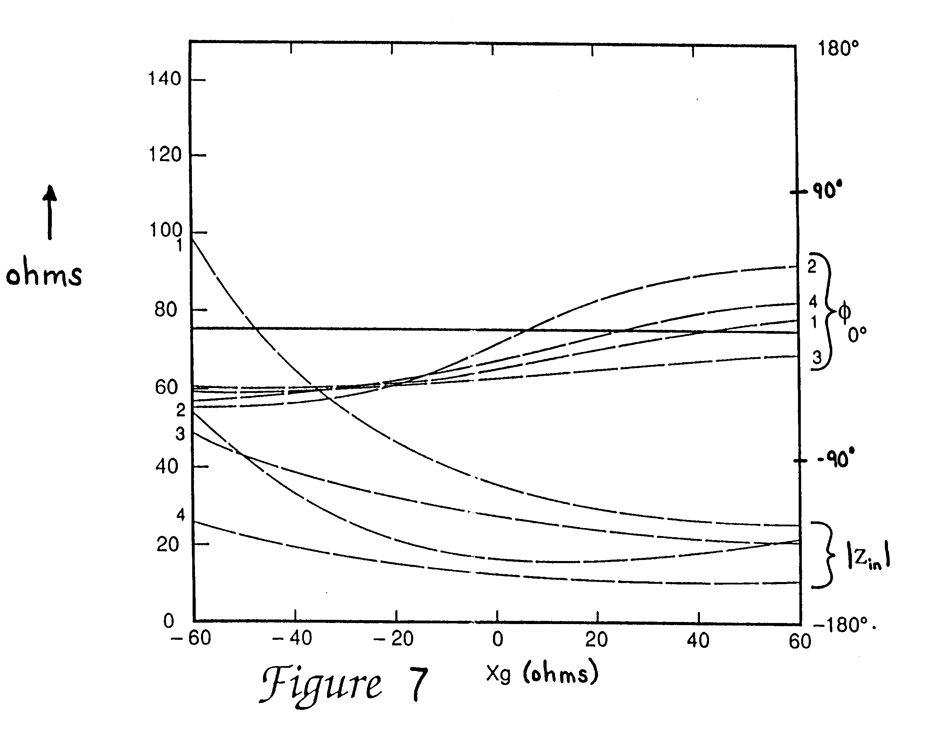

With respect to the first embodiment shown in Figure 1, Figures 5 and 6 show that the voltage split ratio and phase differential remain fairly independent of load impedance (i.e., the four curves are close together) when variable inductor 19 is adjusted over a range which causes the voltage supplied to the first load 17 ($Z_a$) to range from 30% to 100% of the voltage to the second load 18($Z_b$). Also, Figure 6 shows that the phase differential remains within ±45° when the power split ratio is adjusted within this range. This is better constancy than was obtainable with prior art LC power splitter networks. Figure 7 shows the input impedance of the RF power splitter over the same range of conditions.

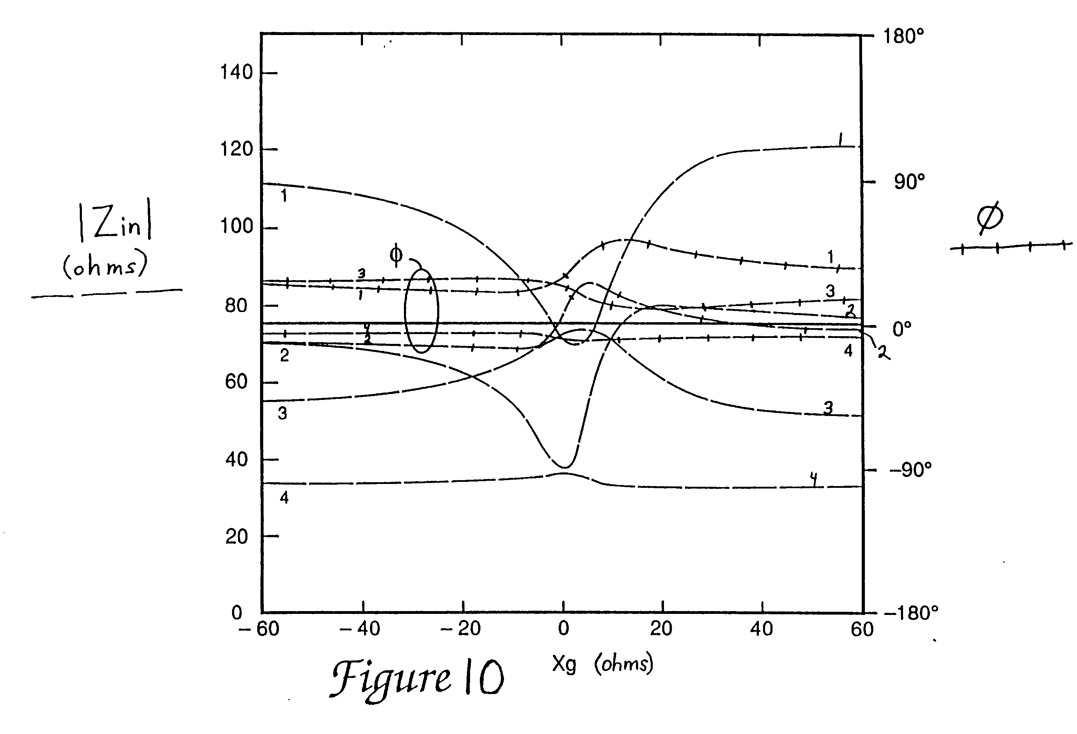

With respect to the second embodiment shown in Figure 2, Figures 8 and 9 show that the sensitivity of the voltage split ratio to changes in load impedance is greater (i.e., worse) than in the first embodiment. However, the second embodiment maintains a more constant phase differential between the two output signals when either the power split ratio or the load impedances are varied. Therefore, which embodiment is preferable depends whether it is more important in a given application to maintain a constant relative amplitude or a constant relative phase differential between the two output signals. Figure 10 shows the input impedance for the second embodiment over the same range of conditions.

Although only two embodiments have been described, it is dear that additional embodiments can be constructed by interchanging the four components connected to the three mutually coupled inductors, that is, by interchanging the connection points of the power source 10, the two output loads 17 and 18, and the variable reactance 19. For example, in Figure 2 the power source 10 could be interchanged with either the first output load 17 or the variable reactance 19. In addition, any of the three inductors 14-16 can be reversed end-to-end to alter the phase relationships of the output signals.

As demonstrated by the preceding description, an RF power splitter having the novel LC network topology of the present invention which incorporates three mutually coupled inductors and a variable reactance has performance attributes not found in the prior art. Specifically, it is superior when dynamically varying loads, such as a plasma in a reaction chamber, must be driven while maintaining an output voltage split ratio and phase differential which is relatively independent of fluctuating load impedance. It also permits the voltage split ratio to be adjusted over a wide range with minimal variation in the phase angle between the output signals. Lastly, it is suitable for implementation without mechanical moving parts or switch contacts.

## Claims

1. An RF power splitter (10) for coupling inputted power to two outputs , wherein the ratio of RF voltage coupled to the two outputs is adjustable, comprising:

   first, second and third mutually coupled inductors (14,15,16) connected in series so that the first inductor (14) is connected between a first electrical junction and a second junction, the second inductor (15) is connected between the second junction and a third junction, and the third inductor (16) is connected between the third junction and a fourth junction;

   an input terminal and a reference terminal adapted for receiving an RF power input signal there between, the input terminal being connected to one of the four junctions; characterised in that the RF power splitter further comprises:

   a variable reactance (19) whose impedance is adjustable over a range, the variable reactance (19) being connected between one of the other three junctions and the reference terminal;

   a first output terminal connected to one of the other two junctions; and

   a second output terminal connected to the remaining junction;

   whereby first and second output voltages are produced between the first and second output terminals, respectively, and the reference terminal, and whereby adjusting the variable reactance operates to vary the ratio between the first and second voltages.

2. A power splitter (10) according to claim 1, wherein the junction to which the input terminal is connected is the first junction.

3. A power splitter according to one of claims 1 or 2, wherein the first, second, and third inductors (14,15,16) are constructed by winding first, second, and third coils, respectively, around a common ferromagnetic core (40).

4. A power splitter (10) according to any of claims 1 to 3, wherein the variable reactance (19) resonates at the frequency of the RF input signal when the variable reactance (19) is adjusted to a point near the middle of its adjustment range, whereby the variable reactance (19) can be adjusted to a capacitive impedance at one end of its adjustment range and to an inductive impedance at the opposite end of its adjustment range.

5. A power splitter (10) according to any of claims 1 to 4, wherein the variable reactance comprises a fixed inductor in series with a variable capacitor.

6. A power splitter (10) according to any of claims 1 to 4, wherein the variable reactance comprises a fixed capacitor (22) in series with a variable inductor (20).

7. A power splitter (10) according to claim 6, wherein the variable inductor (20) comprises a coil (32,34) wound on a non-linear ferromagnetic core (30), and wherein a magnetic field of adjustable intensity is applied to the non-linear core (30) to adjust the inductance of the variable inductor (20).

**Patentansprüche**

1. HF-Leistungsteiler (10) zum Koppeln eingegebener Leistung mit zwei Ausgängen, wobei das Verhältnis der HF-Spannung, welche mit den zwei Ausgängen gekoppelt ist, einstellbar ist, mit:

einem ersten, zweiten und dritten Induktor (14, 15, 16), die miteinander verbunden sind und in Reihe geschaltet sind, so daß der erste Induktor (14) zwischen einem ersten elektrischen Anschluß und einem zweiten Anschluß angeschlossen ist, der zweite Induktor (15) zwischen dem zweiten Anschluß und einem dritten Anschluß angeschlossen ist und der dritte Induktor (16) zwischen dem dritten Anschluß und einem vierten Anschluß angeschlossen ist;

einem Eingangsanschlußpunkt und einem Referenzanschlußpunkt zum Erhalten eines HF-Leistungseingabesignals dazwischen, wobei der Eingangsanschlußpunkt an einen der vier Anschlüsse angeschlossen ist; dadurch gekennzeichnet, daß der RF-Leistungsteiler des weiteren folgendes aufweist:

eine variable Reaktanz (19), deren Impedanz über einen Bereich einstellbar ist, wobei die variable Reaktanz (19) zwischen einem der anderen drei Anschlüsse und dem Referenzanschlußpunkt angeschlossen ist;

einen ersten Ausgangsanschlußpunkt, welcher an einen der anderen zwei Anschlüsse angeschlossen ist;

einen zweiten Ausgangsanschlußpunkt, welcher an den restlichen Anschluß angeschlossen ist;

wobei die erste und die zweite Ausgangsspannung zwischen dem ersten bzw. dem zweiten Ausgangsanschlußpunkt und dem Referenzanschlußpunkt erzeugt werden, und wobei eine Einstellung der variablen Reaktanz eine Variierung des Verhältnisses zwischen der ersten und der zweiten Spannung bewirkt.

2. Leistungsteiler (10) gemäß Anspruch 1, bei dem der Anschluß, an welchen der Eingangsanschlußpunkt angeschlossen ist, der erste Anschluß ist.

3. Leistungsteiler (10) gemäß einem der Ansprüche 1 oder 2, bei dem der erste, der zweite und der dritte Induktor (14, 15, 16) durch Wickeln einer ersten, einer zweiten bzw. einer dritten Spule um einen gemeinsamen ferromagnetischen Kern (40) gebildet sind.

4. Leistungsteiler (10) gemäß einem der Ansprüche 1 bis 3, bei dem die variable Reaktanz (19) mit der Frequenz des HF-Eingangssignals mitschwingt, wenn die variable Reaktanz (19) auf einen Wert nahe der Mitte ihres Einstellbereichs eingestellt ist, wobei die variable Reaktanz (19) auf eine kapazitive Impedanz an einem Ende ihres Einstellbereichs und auf eine induktive Impedanz am gegenüberliegenden Ende ihres Einstellbereichs einstellbar ist.

5. Leistungsteiler (10) gemäß einem der Ansprüche 1 bis 4, bei dem die variable Reaktanz einen festen Induktor in Reihe mit einem einstellbaren Kondensator aufweist.

6. Leistungsteiler (10) gemäß einem der Ansprüche 1 bis 4, bei dem die variable Reaktanz einen Festkondensator (22) in Reihe mit einem variablen Induktor (20) aufweist.

7. Leistungsteiler (10) gemäß Anspruch 6, bei dem der variable Induktor (20) eine Spule (32, 34) aufweist, welche auf einen nichtlinearen ferromagnetischen Kern (30) gewickelt ist, und wobei ein Magnetfeld einstellbarer Intensität an den nichtlinearen Kern (30) angelegt ist, um die Induktivität des variablen Induktors (20) einzustellen.

## Revendications

1. Diviseur de puissance radio-fréquence (10) destiné à coupler une puissance d'entrée à deux sorties, dans lequel le rapport de la tension radio-fréquence couplée aux deux sorties est réglable, comprenant :

   de première, seconde et troisième bobines d'inductance (14, 15, 16) couplées mutuellement, montées en série de manière à ce que la première bobine d'inductance (14) soit montée entre une première jonction électrique et une seconde jonction, la seconde bobine d'inductance (15) étant montée entre la seconde jonction et une troisième jonction et la troisième bobine d'inductance (16) étant montée entre la troisième jonction et une quatrième jonction ;
   une borne d'entrée et une borne de référence adaptées à recevoir entre elles un signal d'entrée de puissance radio-fréquence, la borne d'entrée étant connectée à l'une des quatre jonctions ; caractérisé en ce que le diviseur de puissance radio-fréquence comprend en outre :
   une réactance variable (19) dont l'impédance est réglable sur une gamme, la réactance variable (19) étant montée entre l'une des trois autres jonctions et la borne de référence ;
   une première borne de sortie connectée à l'une des deux autres jonctions ; et
   une seconde borne de sortie connectée à la jonction restante ;
   grâce à quoi de première et seconde tensions de sortie sont produites entre les première et seconde bornes de sortie, respectivement, et la borne de référence, et grâce à quoi le réglage de la réactance variable commande la variation du rapport entre les première et seconde tensions.

2. Diviseur de puissance (10) selon la revendication 1, dans lequel la jonction à laquelle la borne d'entrée est connectée est la première jonction.

3. Diviseur de puissance selon l'une des revendications 1 ou 2, dans lequel les première, seconde et troisième bobines d'inductance (14, 15, 16) sont fabriquées en enroulant un premier, second et troisième bobinages, respectivement, autour d'un noyau ferromagnétique commun (40).

4. Diviseur de puissance (10) selon l'une quelconque des revendications 1 à 3, dans lequel la réactance variable (19) résonne à la fréquence du signal d'entrée radio-fréquence lorsque la réactance variable (19) est réglée à un point proche du milieu de sa gamme de réglage, grâce à quoi la réactance variable (19) peut être réglée à une impédance capacitive à une extrémité de sa gamme de réglage et à une impédance inductive à l'extrémité opposée de sa gamme de réglage.

5. Diviseur de puissance (10) selon l'une quelconque des revendications 1 à 4, dans lequel la réactance variable comprend une bobine d'inductance fixe montée en série avec un condensateur variable.

6. Diviseur de puissance (10) selon l'une quelconque des revendications 1 à 4, dans lequel la réactance variable comprend un condensateur fixe (22) monté en série avec une bobine d'inductance variable (20).

7. Diviseur de puissance (10) selon la revendication 6, dans lequel la bobine d'inductance variable (20) comprend un bobinage (32, 34) enroulé sur un noyau ferromagnétique non linéaire (30), et dans lequel un champ magnétique d'intensité réglable est appliqué au noyau non linéaire (30) pour régler l'inductance de la bobine d'inductance variable (20).

*Figure 1*

*Figure 2*

*Figure 3*

*Figure 4*

Figure 5

8

Figure 6

EP 0 598 390 B1

Figure 7

Figure 8

Figure 9

Figure 10